# EUROPEAN PATENT SPECIFICATION

(11) **EP 2 464 706 B1**
(45) Date of publication and mention of the grant of the patent: **02.09.2015**
(21) Application number: 10747344.9
(22) Date of filing: 10.08.2010
(51) Int. Cl.: C09K 5/14, H01L 23/373, H01L 23/552, H05K 9/00, C09D 5/34, C08L 83/04

(54) **FULLY-CURED THERMALLY OR ELECTRICALLY-CONDUCTIVE FORM-IN-PLACE GAP FILLER**
VOLLSTÄNDIG GEHÄRTETER THERMISCH ODER ELEKTRISCH LEITENDER FORM-IN-PLACE-LÜCKENFÜLLER
AGENT DE REMPLISSAGE D'ESPACE FORMÉ EN PLACE TOTALEMENT DURCI THERMIQUEMENT OU ÉLECTRIQUEMENT CONDUCTEUR

(30) Priority: 12.08.2009 US 233186 P
(43) Date of publication of application: 20.06.2012
(73) Proprietor: Parker Hannifin Corp., Cleveland, OH 44124-4141 (US)
(72) Inventor: BERGIN, Jonathan, Hollis, NH 03049 (US); SANTA FE, Victoria, Manchester, New Hampshire 03103 (US); BUNYAN, Michael, Chelmsford, Massachusetts 01824 (US)
(74) Representative: Belcher, Simon James
(86) International application number: PCT/US2010/045021
(87) International publication number: WO 2011/019719

(56) References cited:
- EP-A1- 0 643 552
- US-A- 6 017 587
- US-A1- 2003 047 718
- US-A1- 2003 222 249
- US-B1- 6 479 580

## Description

The present invention relates broadly to thermally and/or electrically-conductive compounds which may be used as gap fillers or caulks between, for example, the surfaces of an electronic component and another member, such as a heat sink or circuit board, for the conductive cooling and/or the electromagnetic interference (EMI) shielding thereof. Such compound is provided in the form of a cured polymer gel component which is blended with a curable resin component and filled with thermally and/or electrically-conductive particulates. The invention relates in particular to the application, such as by dispensing through a nozzle or other opening such as a printing screen or stencil, of such a compound to one of such surfaces or into a gap between such surfaces.

Circuit designs for modem electronic devices such as televisions, radios, computers, medical instruments, business machines, communications equipment, and the like have become increasingly complex. For example, integrated circuits have been manufactured for these and other devices which contain the equivalent of hundreds of thousands of transistors. Although the complexity of the designs has increased, the size of the devices has continued to shrink with improvements in the ability to manufacture smaller electronic components and to pack more of these components in an ever smaller area.

As electronic components have become smaller and more densely packed on integrated boards and chips, designers and manufacturers now are faced with the challenge of how to dissipate the heat which is ohmicly or otherwise generated by these components. Indeed, it is well known that many electronic components, and especially power semiconductor components such as transistors and microprocessors, are more prone to failure or malfunction at high temperatures. Thus, the ability to dissipate heat often is a limiting factor on the performance of the component.

Electronic components within integrated circuits traditionally have been cooled via forced or convective circulation of air within the housing of the device. In this regard, cooling fins have been provided as an integral part of the component package or as separately attached thereto for increasing the surface area of the package exposed to convectively-developed air currents. Electric fans additionally have been employed to increase the volume of air which is circulated within the housing. For high power circuits and the smaller but more densely packed circuits typical of current electronic designs, however, simple air circulation often has been found to be insufficient to adequately cool the circuit components.

Heat dissipation beyond that which is attainable by simple air circulation may be effected by the direct mounting of the electronic component to a thermal dissipation member such as a "cold plate" or other heat sink or spreader. The dissipation member may be a dedicated, thermally-conductive ceramic or metal plate or finned structure, or simply the chassis or circuit board of the device. However, beyond the normal temperature gradients between the electronic component and the dissipation member, an appreciable temperature gradient is developed as a thermal interfacial impedance or contact resistance at the interface between the bodies.

That is, and as is described in US-4869954, the faying thermal interface surfaces of the component and heat sink typically are irregular, either on a gross or a microscopic scale. When the interfaces surfaces are mated, pockets or void spaces are developed between them in which air may become entrapped. These pockets reduce the overall surface area contact within the interface which, in turn, reduces the heat transfer area and the overall efficiency of the heat transfer through the interface. Moreover, as it is well known that air is a relatively poor thermal conductor, the presence of air pockets within the interface reduces the rate of thermal transfer through the interface.

To improve the heat transfer efficiency through the interface, a pad or other layer of a thermally-conductive, electrically-insulating material often is interposed between the heat sink and electronic component to fill in any surface irregularities and eliminate air pockets. Initially employed for this purpose were materials such as silicone grease or wax filled with a thermally-conductive filler such as aluminium oxide. Such materials, as may be further described in US-5250209, US-5167851, US-4764845, US-4473113, US-4473113, US-4466483 and US-4299715, are usually semi-liquid or solid at normal room temperature, but may liquefy or soften at elevated temperatures to flow and better conform to the irregularities of the interface surfaces.

Known greases and waxes of the types mentioned above are generally not self-supporting or otherwise form stable at room temperature and are considered to be messy to apply to the interface surface of the heat sink or electronic component. To provide these materials in the form of a film which often is preferred for ease of handling, a substrate, web, or other carrier must be provided which introduces another interface layer in or between which additional air pockets may be formed. Moreover, use of such materials typically involves hand application or lay-up by the electronics assembler which increases manufacturing costs.

Alternatively, another approach is to substitute a cured, sheet-like material in place of the silicone grease or wax. Such materials may be compounded as containing one or more thermally-conductive particulate fillers dispersed within a polymeric binder, and may be provided in the form of cured sheets, tapes, pads, or films. Typical binder materials include silicones, urethanes, thermoplastic rubbers, and other elastomers, with typical fillers including aluminium oxide, magnesium oxide, zinc oxide, boron nitride, and aluminium nitride.

Exemplary of the aforesaid interface materials is are alumina or boron nitride-filled silicone or urethane elastomers which are marketed under the trade marks CHO-THERM and THERM-A-GAP by the Chomerics Division of Parker-Hannifin Corporation, 77 Dragon Court, Woburn, MA 01801. Additionally, US-4869954 discloses a cured, form-stable, sheet-like, thermally-conductive material for transferring thermal energy. The material is formed of a urethane binder, a curing agent, and one or more thermally conductive fillers. The fillers, which may include aluminium oxide, aluminium nitride, boron nitride, magnesium oxide, or zinc oxide, range in particle size from about 1 to 50 µm (0.05 × 10⁻³ to 2 × 10⁻³ inch). Similar materials may be described in US-5679457, US-5545473, US-5533256, US-5510174, US-5471027, US-5359768, US-5321582, US-5309320, US-5298791, US-5213868, US-5194480, US-5151777, US-5137959, US-5060114, US-4979074, US-4974119, US-4965699, US-4869954, US-4842911, US-4782893, US-4685987, US-4654754, US-4606962, US-4602678 and WO-96/37915. Other materials, as maybe described in US-6031025, US-5929138, US-5741877, US-5665809, US-5467251, US-5079300, US-4852646, WO-96/05602, WO-00/63968 and EP-A-643551, may use a gel or gel-like material as a binder or carrier for the filler.

Sheets, pads, and tapes of the above-described types have garnered general acceptance for use as interface materials in the conductive cooling of electronic component assemblies such as the semiconductor chips, i.e., dies, described in US-5359768. In certain applications, however, heavy fastening elements such as springs, clamps, and the like are required to apply enough force to conform these materials to the interface surfaces in order to attain enough surface for efficient thermal transfer. Indeed, for some applications, materials such as greases and waxes which liquefy, melt, or soften at elevated temperature continue to be preferred as better conforming to the interface surfaces under relatively low clamping pressures.

Recently, phase-change materials have been introduced which are self-supporting and form-stable at room temperature for ease of handling, but which liquefy or otherwise soften at temperatures within the operating temperature range of the electronic component to form a viscous, thixotropic phase which better conforms to the interface surfaces. These phase-change materials, which may be supplied as free-standing films, or as heated screen printed onto a substrate surface, advantageously function much like greases and waxes in conformably flowing within the operating temperature of the component under relatively low clamping pressures of about 35 kPa (5 psi). Such materials are further described in US-6054198 and US patent application no. 09/212111 (from which priority was claimed in WO-A-00/36893), and are marketed commercially under the trade marks THERMFLOW T310, T443, T705, T710, T725, and A725 by the Chomerics Division of Parker-Hannifin Corporation. Other phase-change materials are marketed commercially by the Bergquist Company (Minneapolis, MN) under the trade mark HI-FLOW, by Thermagon Inc (Cleveland, OH) under the trade marks T-PCM and by Orcus Inc (Stilwell KS) under the trade mark THERMAPHASE. A phase-change material/metal foil laminate is marketed by Thermagon Inc under the trade mark T-MATE.

For typical commercial application, the thermal interface material may be supplied in the form of a tape or sheet which includes an inner and outer release liner and an inter-layer of thermal compound. Unless the thermal compound is inherently tacky, one side of the compound layer may be coated with a thin layer of a pressure-sensitive adhesive (PSA) for the application of the compound to the heat transfer surface of a heat sink. In order to facilitate automated dispensing and application, the outer release liner and compound interlayer of the tape or sheet may be die cut to form a series of individual, pre-sized pads. Each pad thus may be removed from the inner release liner and bonded to the heat sink using the adhesive layer in a conventional "peel and stick" application which may be performed by the heat sink manufacturer.

With the pad being adhered to the heat transfer surface of the thermal dissipation member such as a heat sink or spreader, and with the outer liner in place to form a protective cover the outer surface of the compound layer, the dissipation member and pad may be provided as an integrated assembly. Prior to installation of the assembly, the outer release liner is removed from the compound layer, and the pad positioned on the electronic component. A clamp may be used to secure the assembly in place.

Other materials, as exemplified in US-5467251, US-7208192 and US-5781412, and as marketed commercially by the Chomerics Division of Parker-Hannifin Corporation under the trade mark THERM-A-FORM , are commonly referred to as thermal interface compounds, caulks, form-in-place materials, or encapsulants. These materials typically are supplied as charged within one or more tubes, containers, and the like as, most often, one or two-part liquid or otherwise fluent, filled reactive systems which cure at room or elevated temperatures to be formed-in-place within the gap or component to which the compound is applied. Application may be cartridge or tube guns or other dispensing systems.

EP-A-643552 discloses a gasket composition which is formed as a mixture of a moisture-curable primary polymer and an elastomer which does reach with itself or the primary polymer. A filler is also included.

In view of the variety of materials and applications, as exemplified in the foregoing, used in thermal management, it is to be expected that continued improvements in such materials and applications in thermal management materials would be well-received by electronics manufacturers.

The present invention is concerned generally with a thermally and/or electrically-conductive compound which is dispensable under an applied pressure as a bead, mass, pattern, or other form as issued from a nozzle or as printed through the openings in a screen or stencil, or as otherwise dispensable through an orifice. An amount of the compound, which may be charged in a tube, cartridge, or other container, may be dispensed onto a surface which forms a gap with an opposing, faying, mating, or otherwise adjoining surface, or directly into the gap formed between the adjoining surface. As applied, the compound forms a bead or mass of material "in place". Within the gap, the formed-in-place bead or mass of the compound functions as an interface material in being conformable to at least partially fill the gap and to thereby provide a thermally and/or electrically-conductive pathway between the surfaces.

The invention provides a method of filling a space between a first and a second surface to form an assembly, as defined in claim 1.

The invention makes use of a compound which includes as a major component a substantially fully cross-linked or otherwise cured gel component, such as is more fully described in US-7208192. By combining a curable resin component with the gel component, the compound may be formulated to remain dispensable and soft for use as a gel pad or other interface material, but to further cure following dispensing and deflecting so as to limit migration between components within an electronic device or other application. The combination of the curable resin and gel components, moreover, allows for the bead, pad, or other dispensed form of the compound to initially develop, prior to or following deflection, a cured outer layer or skin to function as a "resin dam" for containing the compound within relatively thick or deep gaps and joints.

The compound used in the method of the present invention, as charged within the tube, cartridge, or other container, or as otherwise supplied, may be stored at room temperature and does not require refrigerated or other special storage. The compound also, while being of a fluent viscosity which is dispensable under an applied pressure, is generally viscoelastic and, as filled, exhibits no appreciable settling of the filler. Such compound also has, effectively, an unlimited shelf-life and working time, and can be provided as a one-part system which does not require mixing by the user prior to dispensing, or a cure schedule following dispensing. The dispensed compound, whether applied as a bead, mass, or other form, is generally form-stable and thereby may be handled for assembly similar to a conventional moulded or extruded strip, pad, sheet, or other preform. The dispensed bead or mass, moreover, while being form-stable is also extremely soft and conformable requiring low or substantially no force in deflection. The compound may be applied using automated dispensing equipment, or otherwise applied such with a pneumatically or manually-operated applicator gun.

In an illustrative embodiment, the compound is formulated as being fluent under an applied pressure, yet form-stable as applied to a surface or within a gap, as a blend or other admixture of: (I) a polymer gel component; (II) a curable resin component; and (III) a filler which may be thermally and/or electrically-conductive particles or a blend thereof. The gel component may be, for example, a thermoplastic gel or a silicone gel which may be an organopolysiloxane. The curable resin component may be a room-temperature vulcanizing (RTV), moisture-curable silicone resin. Advantageously, the compound may be filled, such as to a loading level of between about 20-90% by total weight, to exhibit a thermal conductivity of at least about 0.5 W/m-K which is comparable to that exhibited by current moulded or form-in-place materials, but while still being dispensable using conventional equipment.

Advantages of the present invention include a substantially fully-cured thermal or electrical compound which is dispensable for form-in-place application, but which allows for an additional safety margin of "further" curing in-place. Further advantages include a soft and conformable compound which has fast, form stable dispense rates, low-force deflections during assembly and further cure in application for a robust, shock and vibration absorbing thermal or electrical assembly.

For a fuller understanding of the invention, reference should be had to the following detailed description taken in connection with the accompanying drawings wherein:
Fig. 1 is a perspective, somewhat schematic view of a representative application of the thermally and/or electrically-conductive compound as dispensed onto a surface.
Fig. 2. is a cross-sectional view showing a surface, such as the surface of Fig. 1, being disposed in opposing a mating surface to form an interface gap between them, with an applied bead, mass, or other form of the compound being shown to be conformable between the surfaces to at least partially fill the gap.
Fig. 3 is a cross-sectional view showing an alternative application of the compound as a caulk.

The drawings will be described further in connection with the following description of the invention.

Certain terminology may be employed in the description to follow for convenience rather than for any limiting purpose. For example, the terms "forward", "rearward", "right", "left", "upper" and "lower" designate directions in the drawings to which reference is made, with the terms "inward", "interior", "inner" or "inboard" and "outward", "exterior", "outer" or "outboard" referring, respectively, to directions toward and away from the centre of the referenced element, and the terms "radial" or "horizontal" and "axial" or "vertical" referring, respectively, to directions, axes, planes perpendicular and parallel to the central longitudinal axis of the referenced element. Terminology of similar import other than the words specifically mentioned above likewise is to be considered as being used for purposes of convenience rather than in any limiting sense. Further, the term "EMI shielding" should be understood to include, and to be used interchangeably with, electromagnetic compatibility (EMC), electrical conduction and/or grounding, corona shielding, radio frequency interference (RFI) shielding, and anti-static, i.e., electro-static discharge (ESD) protection.

In the figures, elements having an alphanumeric designation may be referenced herein collectively or in the alternative, as will be apparent from context, by the numeric portion of the designation only. Further, the constituent parts of various elements in the figures may be designated with separate reference numerals which shall be understood to refer to that constituent part of the element and not the element as a whole. General references, along with references to spaces, surfaces, dimensions, and extents, may be designated with arrows.

For the illustrative purposes of the discourse to follow, the thermally and/or electrically-conductive compound used in the invention is principally described in connection with a thermally-conductive formulation. Such formulation may be used within a thermal management assembly as a thermal interface material which may be dispensed under an applied pressure as a bead, mass, pattern, or other form as issued from a nozzle or as printed through the openings in a screen or stencil, or as otherwise dispensed through an orifice onto a heat transfer surface of a thermal dissipation member such as a heat sink for heat transfer contact with a mating heat transfer surface of a electronic component. Such assemblies and thermal interface materials therefor are elsewhere described in US-6096414, US-6054198, US-5798171, US-5766740, US-5679457, US-5545473, US-5533256, US-5510174, US-5471027, US-5359768, US-5321582, US-5309320, US-5298791, US-5250209, US-5213868, US-5194480, US-5137959, US-5167851, US-5151777, US-5060114, US-4979074, US-4974119, US-4965699, US-4869954, US-4842911, US-4782893, US-4764845, US-4685987, US-4654754, US-4606962, US-4602678, US-4473113, US-4466483, US-4299715 and US-3928907. It will be appreciated, however, that the present invention may find use in other thermal management applications, and in other forms such as a caulk. The compound used in the invention, as formulated to be additionally or alternatively electrically-conductive, also may find use as a form-in-place EMI shielding material.

A fluent compound which can be used in the method of the present invention can exhibit, in gross morphological aspects, a continuous gel phase and a discrete phase of a particulate filler dispersed in the continuous phase. Such compound, which is both fluent and viscous or viscoelastic, is especially adapted for use as a form-in-place (FIP) thermal interface or EMI shielding gasket material in being dispensable as a generally non-slumping or otherwise form-stable bead, mass, or other form which is issued from a nozzle or is printed through the openings in a screen or stencil, or is otherwise dispensed through an orifice onto the surface of a substrate such as a heat sink or electronic component. The bead, mass, pattern or other form so dispensed is conformal so as to be capable of filling gaps between adjoining surfaces of the circuitry components, circuit boards, and housings of electronic devices and electrical equipment, or between other adjoining surfaces such as may be found in building structures and the like.

In an exemplary formulation, the compound is formulated as a fluent admixture of (a) a cured polymer gel component, (b) a curable resin component, and (c) a filler component. By "fluent" it is meant that the admixed composition exhibits representative fluid flow characteristics allowing it to be extruded under pressure through a dispensing nozzle, needle, or other orifice, such as a printing screen or stencil, at a given flow velocity. For example, flow rates through a 1 mm (0.047 inch) orifice of about 2 g/min under an applied pressure of about 620 kPa (90 psi) may be observed. The compound, moreover, is provided to be sufficiently viscous or viscoelastic, e.g., about 15 million cps, at about normal room temperature, i.e., about 25 to 30°C, such that the composition may be dispensed from or through a nozzle, needle, screen or other orifice as a generally form-stable bead, mass, pattern or other form. By "form-stable" it is meant that the quantity of the composition which is applied to the substrate exhibits, at steady-state, substantially no appreciable, i.e., 25% or less, slump, sag, running, or other flow, at least at temperatures within the range of normal room temperature. By "cured" it is meant that the gel component, and, unless containing a reactive adjuvant or diluent, the compound itself, does not exhibit, except as may normally develop upon aging, further appreciable polymerization, cross-linking, vulcanization, hardening, drying, or other like chemical or physical change such as from its fluent gel form into a solid or semi-solid form or phase. By "curable" it is meant that the resin component undergoes following dispensing and prior to or following deflection, further appreciable polymerization, cross-linking, vulcanization, hardening, drying, or other like chemical or physical change such as from its fluent viscous or viscoelastic form into a solid or semi-solid form or phase.

Gels useful as the polymer gel component (a) include systems based on silicones, i.e., polysiloxanes, such as polyorganosiloxane, as well as systems based on other polymers, which may be thermoplastic or thermosetting, such as polyurethanes, polyureas, fluoropolymers, chlorosulphonates, polybutadienes, butyls, neoprenes, nitriles, polyisoprenes, and buna-N, copolymers such as ethylene-propylene (EPR), styrene-isoprene-styrene (SIS), styrene-butadiene-styrene (SBS), ethylene-propylene-diene monomer (EPDM), nitrile-butadiene (NBR), styrene-ethylene-butadiene (SEB), and styrene-butadiene (SBR), and blends thereof such as ethylene or propylene-EPDM, EPR, or NBR. As used herein, the term "polymer gel" is ascribed, in one sense, its conventional meaning of a fluid-extended polymer system which may include a continuous polymeric phase or network, which may be chemically, e.g., ionically or covalently, or physically cross-linked, and an oil, such as a silicone or other oil, a plasticizer, unreacted monomer, or other fluid extender which swells or otherwise fills the interstices of the network. The cross-linking density of such network and the proportion of the extender can be controlled to tailor the modulus, i.e., softness, and other properties of the gel.. The term "polymer (or silicone as the case may be) gel" also should be understood to encompass materials which alternatively may be classified broadly as pseudogels or gel-like as having viscoelastic properties similar to gels, such has by having a "loose" cross-linking network formed by relatively long cross-link chains, but as, for example, lacking a fluid-extender.

As to silicone gels, particularly preferred are soft silicone gels such as marketed under the trade mark GEL-8100 by NuSil Technology (Carpinteria, CA). Such gel in its cured condition has a penetration value, such as per ASTM D217, of about 100 × 10⁻¹ mm. Other soft silicone gels are marketed under the designation "3-6636" by Dow Coming (Midland, MI).

Resins useful as the curable resin component (b) include moisture-curable, room-temperature-vulcanizing (RTV) silicones such as described in US-6096413 and US-5910524. Such silicones may be oxime or other condensation curing polymers. The blend of the curable resin component (b) and the cured gel component (a) may comprise between about 5 to 50% by weight of the curable resin component (b) based on the total weight of the components (a) and (b).

The blend of the polymer gel and curable resin components is rendered thermally-conductive via its loading with the filler component (c) which may comprise one or more thermally-conductive particulate fillers. In this regard, the polymer gel component generally forms a binder into which the thermally-conductive filler is dispersed. The filler is included in proportion sufficient to provide the thermal conductivity desired for the intended application, and generally will be loaded at between about 20 to 90% by total weight of the compound. The size and shape of the filler is not critical for the purposes of the present invention. In this regard, the filler may be of any general shape, referred to broadly as "particulate", including solid or hollow spherical or microspherical, flake, platelet, irregular, or fibrous, such as chopped or milled fibres or whiskers, but preferably will be a powder to assure uniform dispersal and homogeneous mechanical and thermal properties. The particle size or distribution of the filler typically will range from between about 0.25 to 250 µm (0.01 × 10⁻³ to 10 × 10⁻³ inch), which may be a diameter, imputed diameter, length, or other dimension of the particulate, but may further vary depending upon the thickness of the gap to be filled. If desired, the filler may be selected as being electrically-nonconductive such that compound may be both dielectric or electrically-insulating and thermally-conductive. Alternatively, the filler may be electrically-conductive in applications where electrical isolation is not required.

Suitable thermally-conductive fillers generally include oxide, nitride, carbide, diboride, graphite, and metal particles, and mixtures thereof, and more particularly boron nitride, titanium diboride, aluminium nitride, silicon carbide, graphite, metals such as silver, aluminium, and copper, metal oxides such as aluminium oxide, magnesium oxide, zinc oxide, beryllium oxide, and antimony oxide, and mixtures thereof. Such fillers characteristically exhibit a thermal conductivity of between about 20 and 50 W/m-K. For reasons of economy, an aluminium oxide, i.e., alumina, may be used, while for reasons of improved thermal conductivity a boron nitride would be considered more preferred. Loaded with the thermally-conductive filler, the compound typically may exhibit a thermal conductivity, per ASTM D5470, of at least about 0.5 W/m-K and a thermal impedance, also per ASTM D5470, of less than about 6°C.cm²/W (1°C.in²/W), but this may vary depending upon the thickness of the compound layer.

The blend of the polymer gel component (a) and the curable resin component (b) is rendered electrically-conductive via its loading with an electrically-conductive filler, which may be provided in addition to, i.e., a blend, or instead of a thermally-conductive filler. Also, depending upon the filler selected, such filler may function as both a thermally and an electrically-conductive filler.

Suitable electrically-conductive fillers include: noble and non-noble metals such as nickel, copper, tin, aluminium, and nickel; noble metal-plated noble or non-noble metals such as silver-plated copper, nickel, aluminium, tin, or gold; non-noble metal-plated noble and non-noble metals such as nickel-plated copper or silver; and noble or non-noble metal plated non-metals such as silver or nickel-plated graphite, glass, ceramics, plastics, elastomers, or mica; and mixtures thereof. The filler again may be broadly classified as "particulate" in form, although the particular shape of such form is not considered critical to the present invention, and may include any shape that is conventionally involved in the manufacture or formulation of conductive materials of the type herein involved including hollow or solid microspheres, elastomeric balloons, flakes, platelets, fibres, rods, irregularly-shaped particles, or a mixture thereof. Similarly, the particle size of the filler is not considered critical, and may be or a narrow or broad distribution or range, but in general will be between about 0.250 and 250 µm.

The filler is loaded in the composition in a proportion sufficient to provide the level of electrical conductivity and EMI shielding effectiveness within the gap which is desired for the intended application. For most applications, an EMI shielding effectiveness of at least 10 dB, and usually at least 20 dB, and preferably at least about 60 dB or higher, over a frequency range of from about 10 MHz to 10 GHz is considered acceptable. Such effectiveness translates to a filler proportion which generally is between about 10 and 90% by volume or 50 and 90% by weight, based on the total volume or weight, as the case may be, of the compound, and a bulk or volume resistivity of not greater than about 1 Ω.cm, although it is known that comparable EMI shielding effectiveness may be achieved at lower conductivity levels through the use of an EMI absorptive or "lossy" filler such as a ferrite or nickel-coated graphite. As is also known, the ultimate shielding effectiveness of member 32 will vary based on the amount of the electrically-conductive or other filler material, and on the film thickness.

Additional fillers and additives may be included in the formulation of the compound depending upon the requirements of the particular application envisioned. Such fillers and additives may include conventional wetting agents or surfactants, pigments, dyes, and other colorants, opacifying agents, anti-foaming agents, anti-static agents, coupling agents such as titanates, chain extending oils, tackifiers, pigments, lubricants, stabilizers, emulsifiers, antioxidants, thickeners, and/or flame retardants such as aluminium trihydrate, antimony trioxide, metal oxides and salts, intercalated graphite particles, phosphate esters, decabromodiphenyl oxide, borates, phosphates, halogenated compounds, glass, silica, which may be fumed or crystalline, silicates, mica, and glass or polymeric microspheres. Typically, these fillers and additives are blended or otherwise admixed with the formulation, and may comprise between about 0.05 and 90% or more by total volume thereof.

The compound may be prepared, for example, in a roll mill or other conventional mixing apparatus as an admixture of one or more resins or other polymers which may also be oligomers or prepolymers, optionally, depending upon the system, a cross-linking agent, catalyst, and extender, the filler component, and optional additive components. Prior to mixing, the polymer gel component (a) may be subjected to conditions which polymer, further polymerize, or otherwise cure or convert the resin, oligomer, or prepolymer into a fluid or non-fluid extended polymer gel component. In this regard, the admixture may be heated, such as in the case of a thermal addition polymerization, i.e., vulcanization or cross-linking, system. Alternatively, the chemical or physical gellation reaction may be under the influence of atmospheric moisture, i.e., hydrolysis, exposure to ultraviolet (UV) radiation, or other curing mechanism such an anaerobic cure.

Depending upon the polymer gel system employed, an inorganic or organic solvent or other diluent or rheological agent may be added to the mixture of the compound to control the viscosity of the final compound which may be adjusted for the application equipment or process to be used. As mentioned, the viscosity of the final compound typically may be about 15 million cps at about 25 to 30°C. The compound may also be foamed prior to or after mixing, such as under the control of a physical blowing agent, such as nitrogen, carbon dioxide, or other gas, or a chemical blowing agent, which may be an organic compound or an inorganic compound such as water, which decomposes or volatilizes to generate a gas. After mixing, the compound may be charged into individual tubes, cartridges, or containers and stored for later application using, for example, a handheld applicator gun or syringe, or, alternatively, automated metering and dispensing equipment such as a robotic applicator.

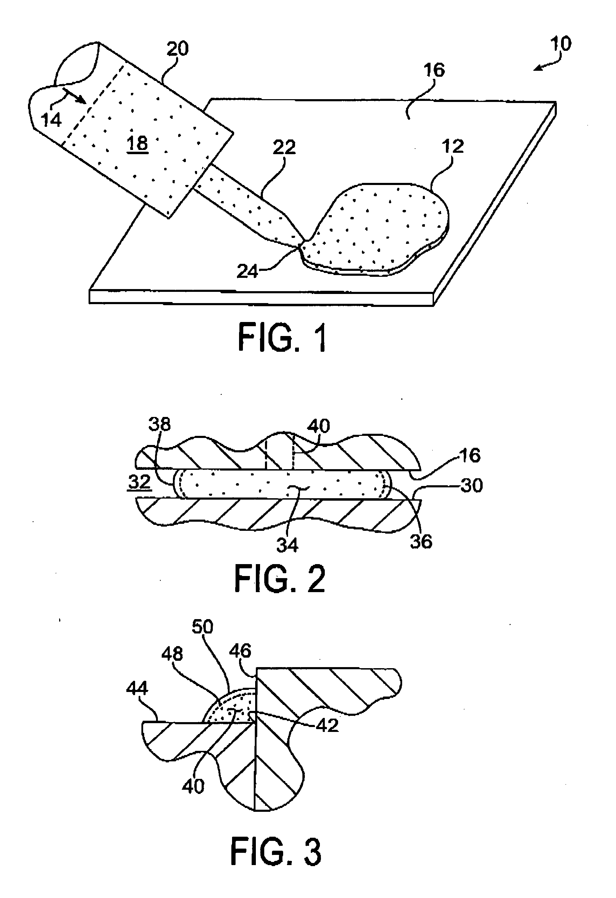

Referring now to the figures wherein corresponding reference characters are used to designate corresponding elements throughout the several views with equivalent elements being referenced with prime or sequential alphanumeric designations, an illustrative dispensed application of the admixed and cured compound of the present invention is shown generally at 10 in Fig. 1. In Fig. 1, an amount 12 of the compound is shown as being dispensed under an applied pressure, illustrated by the arrow 14, on to a primed or unprimed surface 16 which may be a plastic, metal, or ceramic surface of, for example, a heat sink, cold plate, circuit board, housing part, or electronic component. In this regard, a supply of the compound 18 is shown to be charged as a one-part system into a cartridge, tube, or other container, 20, connected in fluid communication, which may be direct as shown or via hose or other conduit connected to a head, with a nozzle 22 having an orifice, 24. The orifice through which the amount 12 of the compound is dispensed alternatively may be openings in a screen or stencil such as in the case of printing-type dispensing applications.

Under the applied pressure 14, which may be manually applied using a gun or syringe, or developed by air or airless metering equipment such as a proportioning cylinder or a pump, a metered amount of the compound may be issued as a pad or other from nozzle 22 and onto the surface 16. As applied, the amount 12 may be substantially self-adherent to the surface 16, such as by surface tension, an inherent tack, or other cohesive force. Unlike a grease or the like, the amount 12 advantageously may be form-stable at normal room temperature such that part or component to which it is applied may be handled for assembly or otherwise. Moreover, unlike conventional form-in-place compounds which may bond to the surfaces, the compound used in the invention may be readily cleaned or otherwise removed from the surfaces 16 for repair or rework.

Turning now to Fig. 2, an assembly view is shown wherein the surface 16 having the applied amount 12 has been disposed in opposition, or other thermal adjacency, to a mating surface 30, which again may be that of a heat sink, cold plate, circuit board, housing part, or electronic component, to define a gap 32 between them which may range, for example, from about 0.05 mm (0.002 inch), or less, to about 2.5 mm (0.1 inch), or more. Within the gap 32, the compound, now referenced as the layer 34, may be seen to conform to the surfaces 16 and 30, and to at least partially fill the gap 32. Advantageously, the conformal deflection of layer 34 may be effected under a relative low or substantially no force, that is, for example, a compression or force deflection of about 25% at about 2 kPa (0.3 psi), and of about 50% at about 6 kPa (1 psi) or less. Prior to following such deflection, a substantially tack-free outer layer or skin, represented at 36, initially may be developed about the margin, referenced at 38, of the layer 34 by virtue of the moisture or other curing of the curable resin component (b). Such skin 36, which may form, for example, between about 5 and 10 minutes following application and, in the case of a moisture-cure resin, exposure to atmospheric moisture, may be developed by virtue of the initial curing of the curable resin component (b). Prior to the further curing of the curable component (b) and resultant increase in the overall viscosity of the compound, the skin 36 may function as a "resin dam" to mitigate the migration of the layer 34 from between the surfaces 16 and 30.

Alternatively, the compound forming the layer 34 may be injected directly into the gap 32, such as via an opening, referenced in phantom at 40, formed through one of the surfaces 16 or 30. Also, and with reference now to Fig. 3, the compound may be applied instead as a bead, 40, such as along a seam, 42, within a gap between adjoining surfaces 44 and 46. In such application, an initial outer skin, represented at 48, may be developed over the exterior surface or other margin, referenced at 50, of the bead 40 prior to the further curing of the curable resin component (b). Such skin 48 similarly functions as a "resin dam" to contain the bead 40 within the seam 42.

## Claims

1. A method of filling a space between a first and a second surface to form an assembly, the method comprising the steps of:
(a) providing a supply of a fluent, form-stable compound comprising an admixture of: (I) an already cured polymer gel component which does not exhibit, except as may normally develop upon aging, further appreciable polymerization, cross-linking, vulcanization, hardening, drying, or other like chemical or physical change such as from its fluent gel form into a solid or semi-solid form or phase, (II) a curable resin component which can undergo following dispensing further appreciable polymerization, cross-linking, vulcanization, hardening, drying, or other like chemical or physical change such as from its fluent viscous or viscoelastic form into a solid or semi-solid form or phase, and (III) a particulate filler component,
(b) dispensing an amount of the compound on to a selected one of the first and second surfaces,
(c) following step (b), forming the space between the first and the second surfaces by disposing the selected one of the first and second surfaces as adjoining the other of the first and second surfaces, the space being at least partially filled by at least a portion of the compound dispensed in step (b),
(d) deflecting the compound dispensed in step (b) between the first and second surfaces so as to fill the space at least partially, and
(e) curing the curable resin component to form a conformable layer in the space.

2. The method of claim 1 in which the compound comprises, by total weight of the components (I), (II) and (III), between about 20 and about 90% of the filler component.

3. The method of claim 1 in which the compound comprises, by total weight of the components (I) and (II), between about 5 and about 50% of the component (II).

4. The method of claim 1 in which the filler component has a mean average particle size of between about 0.25 and about 250 µm (0.01 and 10 mil).

5. The method of claim 1 in which the space formed in step (b) has a thickness of between about 0.05 and about 2.5 mm (2 and 100 mils).

6. The method of claim 1 in which the space is a thermal space, and the filler component is thermally-conductive, preferably with a thermal conductivity of at least about 20 W.m⁻¹.K⁻¹, and/or in which the compound has a thermal conductivity of at least about 0.5 W.m⁻¹.K⁻¹.

7. The method of claim 6 in which the filler component is selected from the group consisting of oxide, nitride, carbide, diboride, graphite, and metal particles, and mixtures thereof.

8. The method of claim 1 in which the compound has a viscosity of about 15 × 10⁶ cps at 25 to 30°C.

9. The method of claim 1 in which the compound is substantially self-adherent to at least the one of the first and the second surface onto which the compound is dispensed in step (b).

10. The method of claim 1 in which the space is an EMI shielding space, and the filler component is electrically-conductive, preferably with an electrical volume resistivity of not greater than about 1 Ω.cm, and/or in which the compound exhibits an EMI shielding effectiveness of at least about 60 dB substantially over a frequency range of between about 10 MHz and about 10 GHz.

11. The method of claim 1 in which the polymer gel component comprises a silicone polymer.

12. The method of claim 1 in which the resin component comprises a silicone resin, preferably a silicone resin which is moisture-curable.

13. The method of claim 1 further comprising the additional step prior to step (b) of providing an orifice connected in fluid communication with the supply of the compound, in which the compound is dispensed in step (b) from the orifice under an applied pressure.

14. The method of claim 13 in which the supply of the compound is provided in step (a) as charged into a container.

15. The method of claim 1 in which the compound is dispensed in step (b) in the form of a pad or a bead, having a margin, and the resin component first cures in step (b) to form a skin about the margin of the pad or bead.

## Patentansprüche

1. Ein Verfahren zum Füllen eines Raumes zwischen einer ersten und einer zweiten Oberfläche um eine Baugruppe zu bilden, wobei das Verfahren die Schritte umfasst:
(a) Bereitstellen eines Vorrats einer flüssigen, formstabilen Zusammensetzung, welche eine Beimischung umfasst aus: (I) einer bereits ausgehärteten Polymergelkomponente, die außer dem, was sich üblicherweise aufgrund von Alterung entwickelt, keine weiter nennenswerte Polymerisation, Vernetzung, Vulkanisation, Aushärtung, Trocknung, oder andere derartige chemische oder physikalische Umwandlung aus derer flüssigen Gel-Form in eine feste oder halbfeste Form oder Phase aufweist, (II) einer härtbare Harzkomponente, die nach Ausbringen eine weiter nennenswerte Polymerisation, Vernetzung, Vulkanisation, Aushärtung, Trocknung, oder andere derartige chemische oder physikalische Umwandlung aus derer viskosen oder viskoelastischen Form in eine feste oder halbfeste Form oder Phase erfahren kann, und (III) einer partikelförmigen Füllerkomponente,
(b) Ausbringen einer Menge der Zusammensetzung auf einer aus den beiden Oberflächen ausgewählten Oberfläche,
(c) nach Schritt (b), Formen des Raumes zwischen der ersten und der zweiten Oberfläche durch Anordnen der ausgewählten Oberfläche als benachbart an der anderen der beiden Oberflächen, wobei der Raum zumindest teilweise durch zumindest einen Teil der in Schritt (b) ausgebrachten Zusammensetzung gefüllt ist,
(d) Verteilen der in Schritt (b) ausgebrachten Zusammensetzung zwischen der ersten und zweiten Oberfläche, um den Raum zumindest teilweise zu füllen,
(e) Härten der härtbaren Harzkomponente, um eine konkordante Schicht in dem Raum zu formen.

2. Das Verfahren nach Anspruch 1, wobei die Zusammensetzung bezogen auf das Gesamtgewicht der Komponenten (I), (II) und (III) zwischen rund 20 und rund 90 % der Füllerkomponente aufweist.

3. Das Verfahren nach Anspruch 1, wobei die Zusammensetzung bezogen auf das Gesamtgewicht der Komponenten (I) und (II) zwischen rund 5 und rund 50 % der Komponente (II) aufweist.

4. Das Verfahren nach Anspruch 1, wobei die Füllerkomponente eine Mittelwertpartikelgröße von zwischen rund 0,25 und rund 250 µm (0,01 und 10 Mil) hat.

5. Das Verfahren nach Anspruch 1, wobei der in Schritt (b) geformte Raum eine Dicke von zwischen rund 0,05 und rund 2,5 mm (2 und 100 Mil) hat.

6. Das Verfahren nach Anspruch 1, wobei der Raum ein thermischer Raum ist, und die Füllerkomponente thermisch leitend ist, vorzugsweise mit einer thermischen Leitfähigkeit von mindestens rund 20 W.m⁻¹.K⁻¹, und/oder wobei die Zusammensetzung eine thermische Leitfähigkeit von mindestens rund 0,5 W.m⁻¹.K⁻¹ hat.

7. Das Verfahren nach Anspruch 6, wobei die Füllerkomponente aus der Gruppe bestehend aus Oxid-, Nitrid-, Karbid-, Diborid-, Grafit- und metallischen Partikeln und Mischungen daraus gewählt ist.

8. Das Verfahren nach Anspruch 1, wobei die Zusammensetzung eine Viskosität von rund 15 x 10⁶ tbs bei 25 bis 30° C hat.

9. Das Verfahren nach Anspruch 1, wobei die Zusammensetzung im Wesentlichen zu der mindestens einen der beiden Oberflächen selbstklebend ist, auf welcher die Zusammensetzung in Schritt (b) ausgebracht ist.

10. Das Verfahren nach Anspruch 1, wobei der Raum ein EMV-Abschirmraum ist, und die Füllerkomponente elektrisch leitend ist, vorzugsweise mit einem spezifischen Durchgangswiderstand von nicht mehr als rund 1 Ω.cm, und/oder wobei die Zusammensetzung eine EMV Abschirmeffektivität von zumindest rund 60 dB im Wesentlichen oberhalb eines Frequenzbereiches von zwischen rund 10 MHz und rund 10 GHz aufweist.

11. Das Verfahren nach Anspruch 1, wobei die Polymergelkomponente ein Silikonpolymer umfasst.

12. Das Verfahren nach Anspruch 1, wobei die Harzkomponente ein Silikonharz umfasst, vorzugsweise ein Silikonharz, welcher feuchtigkeitshärtbar ist.

13. Das Verfahren nach Anspruch 1, welches vor dem Schritt (b) den zusätzlichen Schritt des Bereitstellens einer Öffnung umfasst, welche in Fluidverbindung mit dem Vorrat der Zusammensetzung verbunden ist, wobei die Zusammensetzung in Schritt (b) aus der Öffnung unter Druck ausgebracht wird.

14. Das Verfahren nach Anspruch 13, wobei der Vorrat der Zusammensetzung in Schritt (a) als in einem Druckbehälter gegeben, vorgesehen ist.

15. Das Verfahren nach Anspruch 1, wobei die Zusammensetzung in Schritt (b) in der Form eines Pads oder einer Wulst mit einem Rand ausgebracht wird, und wobei die Harzkomponente zunächst in Schritt (b) härtet, um eine Haut um den Rand des Polsters oder der Wulst zu formen.

## Revendications

1. Procédé de remplissage d'un espace entre une première et une deuxième surfaces pour former un ensemble, le procédé comprenant les étapes qui consistent :
(a) à fournir une alimentation en un composé fluide de forme stable comprenant un mélange : (I) d'un composant de gel polymère déjà durci qui ne présente pas, sauf s'il peut se développer normalement lors du vieillissement, une polymérisation appréciable supplémentaire, une réticulation, une vulcanisation, un durcissement, un séchage, ou un autre changement chimique ou physique similaire tel qu'un changement de sa forme de gel fluide en une forme ou phase solide ou semi-solide, (II) un composant de résine durcissable qui peut subir après distribution une polymérisation appréciable supplémentaire, une réticulation, une vulcanisation, un durcissement, un séchage, ou un autre changement chimique ou physique tel qu'un changement de sa forme visqueuse ou viscoélastique fluide en une forme ou phase solide ou semi-solide, et (III) un composant de charge particulaire,
(b) à distribuer une quantité du composé sur une surface choisie parmi les première et deuxième surfaces,
(c) à former, après l'étape (b), l'espace entre les première et deuxième surfaces en disposant la surface choisie parmi les première et deuxième surfaces de manière adjacente à l'autre surface des première et deuxième surfaces, l'espace étant au moins partiellement rempli par au moins une partie du composé distribué dans l'étape (b),
(d) à faire dévier le composé distribué dans l'étape (b) entre les première et deuxième surfaces de manière à remplir l'espace, au moins partiellement, et
(e) à durcir le composant de résine durcissable pour former une couche conforme dans l'espace.

2. Procédé de la revendication 1 dans lequel le composé comprend, par rapport au poids total des composants (I), (II) et (III), entre environ 20 et environ 90% du composant de charge.

3. Procédé de la revendication 1 dans lequel le composé comprend, par rapport au poids total des composants (I) et (II), entre environ 5 et environ 50% du composant (II).

4. Procédé de la revendication 1 dans lequel le composant de charge a une taille moyenne de particule comprise entre environ 0,25 et environ 250 µm (entre 0,01 et 10 millième(s) de pouce).

5. Procédé de la revendication 1 dans lequel l'espace formé dans l'étape (b) a une épaisseur comprise entre environ 0,05 et environ 2,5 mm (entre 2 et 100 millièmes de pouce).

6. Procédé de la revendication 1 dans lequel l'espace est un espace thermique, et le composant de charge est thermoconducteur, de préférence avec une conductivité thermique d'au moins environ 20 W.m⁻¹.K⁻¹, et/ou dans lequel le composé a une conductivité thermique d'au moins environ 0,5-W.m⁻¹.K⁻¹.

7. Procédé de la revendication 6 dans lequel le composant de charge est choisi dans le groupe constitué d'oxyde, de nitrure, de carbure, de diborure, de graphite et de particules métalliques et de mélanges de ceux-ci.

8. Procédé de la revendication 1 dans lequel le composé a une viscosité d'environ 15*10⁶ cps à 25 à 30°C.

9. Procédé de la revendication 1 dans lequel le composé est sensiblement auto-adhérent à l'une parmi les première et deuxième surfaces sur laquelle le composé est distribué dans l'étape (b).

10. Procédé de la revendication 1 dans lequel l'espace est un espace de blindage EMI, et le composant de charge est électriquement conducteur, de préférence avec une résistivité de volume électrique inférieure ou égale à environ 1 Ω.cm, et/ou dans lequel le composé présente une efficacité de blindage EMI d'au moins environ 60 dB sensiblement sur une plage de fréquences allant d'environ 10 MHz à environ 10 GHz.

11. Procédé de la revendication 1 dans lequel le composant de gel polymère comprend un polymère de silicone.

12. Procédé de la revendication 1 dans lequel le composant de résine comprend une résine de silicone, de préférence une résine de silicone qui est durcissable à l'humidité.

13. Procédé de la revendication 1 comprenant en outre l'étape supplémentaire avant l'étape (b) qui consiste à fournir un orifice relié en communication fluidique avec l'alimentation du composé, où le composé est distribué dans l'étape (b) à partir de l'orifice sous une pression appliquée.

14. Procédé de la revendication 13 dans lequel l'alimentation du composé est prévue dans l'étape (a) à mesure qu'il est chargé dans un récipient.

15. Procédé de la revendication 1 dans lequel le composé est distribué dans l'étape (b) sous la forme d'une plaquette ou d'une bille, ayant une marge, et le composant de résine durcit d'abord dans l'étape (b) pour former une peau autour de la marge de la plaquette ou de la bille.
